# EUROPÄISCHE PATENTSCHRIFT

(11) **EP 1 401 019 B1**
(45) Veröffentlichungstag und Bekanntmachung des Hinweises auf die Patenterteilung: **12.12.2012**
(21) Anmeldenummer: 03010008.5
(22) Anmeldetag: 02.05.2003
(51) Int. Cl.: H01L 23/538, H01L 25/00, H01L 23/498, H01L 23/367, H01L 25/16

(54) **Elektronische Baueinheit, insbesondere Regler für Generatoren in Kraftfahrzeugen**
Electronic device, especially regulator for generators in engine driven vehicles
Dispositif électronique, en particulier régulateur pour générateurs pour des véhicules

(30) Priorität: 20.09.2002 DE 10243981
(43) Veröffentlichungstag der Anmeldung: 24.03.2004
(73) Patentinhaber: ROBERT BOSCH GMBH, 70442 Stuttgart (DE)
(72) Erfinder: Miller, Hans Peter, 70374 Stuttgart (DE); Doeffinger, Andreas, 71229 Leonberg (DE); Henkel, Achim, 72766 Reutlingen (DE)

(56) Entgegenhaltungen:
- EP-A2- 0 884 781
- DE-A1- 4 419 215
- DE-C1- 19 951 916
- JP-A- 62 131 555
- US-A- 5 195 237

## Beschreibung

### Stand der Technik

Die Erfindung betrifft eine elektronische Baueinheit, insbesondere einen Regler für Generatoren in Kraftfahrzeugen, mit einem IC-Baustein, nach dem Oberbegriff des Hauptanspruchs.

Bei den bekannten Reglern mit IC-Bauteilen nach DE 44 19 215 A1 werden für unterschiedliche Leistungen verschiedene Baugrößen eingesetzt, wobei die Verlustleistung der IC-Bauteile über entsprechend dimensionierte Kühlkörper nach außen abgeführt werden muss. Zusatzfunktionen der Regler, wie zum Beispiel ein Schutz gegenüber Spannungspitzen von außen, werden dabei durch zusätzliche Halbleiter-ICs und/oder separat im Regler eingesetzte Bauelemente realisiert, wobei dann sowohl für die zusätzlichen Bauteile als auch für deren Verschaltung über Bonddraht-Anschlüsse ein ausreichend großer Platz im Reglergehäuse benötigt wird. Nachteilig sind dabei die dadurch erforderlichen größeren Abmessungen des Reglers. Da außerdem die elektronischen Bauteile und Anschlüsse zum Schutz gegen Korrosion mit einem Silikongel als Vergussmasse abgedeckt werden, ergibt sich als weiterer Nachteil, dass mit größer werdender Abdeckfläche auch die benötigte Gelmenge größer wird. Das führt insbesondere im rauhen Kraftfahrzeugeinsatz des Reglers bei den dort auftretenden Schüttelbeanspruchungen unter Umständen zu Ablösungen am Silikongel oder Beschädigungen an den Anschlüssen der elektronischen Bauteile. Da ferner die mit dem Silikongel abzudeckende Fläche von einem Rahmen begrenzt wird, muss auf dieser Fläche auch ein ausreichender Platz für das Zu- und Abführen von Bondwerkzeugen innerhalb des Rahmens vorgehalten werden.

EP0884781 offenbart ein Leistungshalbleitermodul mit einer Metailplatte und mehreren Leiterplatten, wobei die Leistungshalbleiter mittels Bonddrähten mit den Leiterbahnen verbunden sind.

Mit der vorliegenden Erfindung wird angestrebt, bei elektronischen Baueinheiten wie Regler und dergleichen den erforderlichen Raum für die Montage und den Anschluss eines IC-Bausteines und mindestens eines wahlweise zusätzlich einzusetzenden elektronischen Bauteiles möglichst gering zu halten.

### Vorteile der Erfindung

Die erfindungsgemäße elektronische Baueinheit hat mit den kennzeichnenden Merkmalen des Hauptanspruchs den Vorteil, dass bei gleichem Einbauraum die zu den Steckanschlüssen führenden Leiter sowohl bei einem Regler mit zusätzlichen elektronischen Bauteilen als auch bei einem Regler ohne solche zusätzlichen Bauteile verwendet werden. Ein weiterer Vorteil besteht darin, dass die vom Korrosionsschutzgel abgedeckte Fläche im Regler durch die Möglichkeiten einer wahlweisen Anordnung zusätzlicher elektronischer Bauteile durch die jeweils zweite Bondstelle sich nicht oder nur minimal vergrößert. Ferner ist es von Vorteil, dass bei der wahlweisen Verwendung diskreter Zusatzkomponenten die Bonddraht-Anschlüsse jeweils kurz gehalten werden können, um mechanische Schwingungen beim Betrieb zu vermeiden. Schließlich lässt sich durch die Verwendung zusätzlicher diskreter Komponenten auch die elektrische Robustheit des Reglers steigern, was andernfalls nur sehr kostenintensiv durch monolithische Integration auf dem IC-Baustein realisierbar wäre.

Durch die in den Unteransprüchen aufgeführten Maßnahmen ergeben sich vorteilhafte Weiterbildungen und Verbesserungen der im Hauptanspruch angegebenen Merkmale. So ist es zur Begrenzung des von der Vergussmasse abzudeckenden Raumes von Vorteil, den Abstand zwischen dem ersten und dem zweiten Bondpad der Leiter als begrenzten Freiraum für das Zu- und Abführen des Bondwerkzeuges zu den beiden Bondpads mehrfach zu nutzen. Ferner ist es zur Erzielung möglichst kurzer Bonddraht-Anschlüsse von Vorteil, wenn die Bonddraht-Anschlüsse des IC-Bausteines wahlweise direkt an den ersten Bondpads oder indirekt über das mindestens eine zusätzliche elektronische Bauteil an den zweiten Bondpads mit den Leitern verbunden sind. In einfacher Weise sind dabei die Leiter als Stromschienen, vorzugsweise als Einlegeteile, weitgehend in Isolierstoff eingebettet. In zweckmäßiger Ausgestaltung der Erfindung sind dabei mehrere zusätzliche elektronische Bauteile auf einer Substratplatte verschaltet, die zwischen dem IC-Baustein und den zweiten Bondpads der Leiter angeordnet ist und dabei zweckmäßigerweise auf den ersten Bondpads an den dem IC-Baustein zugewandten Enden der Leiter aufliegt. Dabei sind der IC-Baustein, die wahlweise zusätzliche Substratplatte mit den diskreten elektronischen Bauteilen und die Bondpads der Leiter von einem Rahmen eingefasst und innerhalb des Rahmens von einer Vergussmasse abgedeckt. Auf der Substratplatte können gegebenenfalls weitere Bereiche genutzt werden, um Anschlüsse zu anderen Potentialen, wie zum Beispiel Plus oder Masse herzustellen.

### Zeichnung

Die Erfindung wird im Folgenden beispielsweise anhand der Figuren näher erläutert. Es zeigen:
Figur 1 einen Regler für Kraftfahrzeug-Generatoren ohne Abdeckung mit seinem IC-Baustein und ohne zusätzliche Komponenten in der Draufsicht,
Figur 2 zeigt einen Querschnitt nach der Linie II-II aus Figur 1 durch den Regler,
Figur 3 zeigt den Regler nach Figur 1 mit zusätzlichen Komponenten auf einer alternativ einsetzbaren Substratplatte und
Figur 4 zeigt einen Schnitt nach der Linie IV-IV des Reglers aus Figur 3.

### Beschreibung der Ausführungsbeispiele

Die Figuren zeigen einen Regler 15, 15a für einen Drehstromgenerator, der ausgangsseitig über eine Gleichrichter-Baueinheit das Bordnetz von Kraftfahrzeugen versorgt. Der Erregerstrom wird dabei in Abhängigkeit von der am Ausgang der Gleichrichter-Baueinheit auftretenden Spannung des Kraftfahrzeug-Bordnetzes über den Regler 15, 15a geregelt.

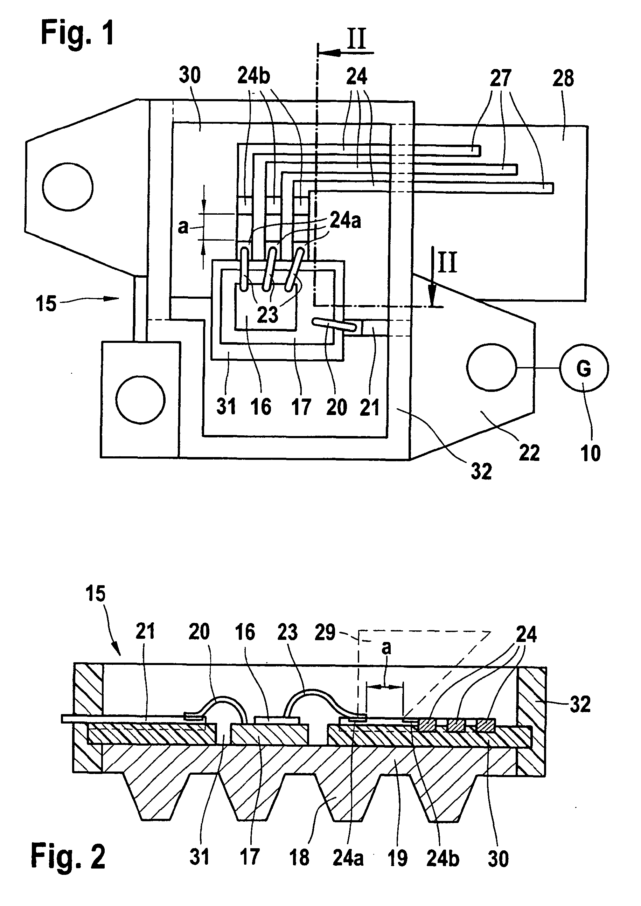

Die Figuren 1 und 2 zeigen den geöffneten Regler 15 in einer Ausführungsform mit einem IC-Baustein 16 ohne zusätzliche diskrete Komponenten. Zur Aufnahme der Verlustwärme im IC-Baustein 16 ist dieser unmittelbar auf einen Metallblock 17 festgeklebt. Der Metallblock 17 sitzt wiederum auf einem relativ großen, mit Kühlrippen 18 versehenen Kühlkörper 19, über den die vom Metallblock 17 aufgenommene Verlustwärme des IC-Baustein 16 verteilt an einen Kühlluftstrom des Generators abgegeben werden kann. Der Metallblock 17 wird über einen Bonddrahtanschluss 20 auf Massepotential gelegt, in dem der Bonddrahtanschluss 20 zu einer Zunge 21 einer Anschlussplatte 22 führt, die an die Masse des Drehstromgenerators 10 angeschlossen wird. Ferner ist der IC-Baustein 16 über drei nebeneinander liegende Bonddraht-Anschlüsse 23 mit drei nebeneinander liegenden Leitern in Form von Stromschienen 24 elektrisch verbunden, die zu Steckanschlüssen 27 eines Steckerteiles 28 führen. Die Stromschienen 24 sind an ihren dem IC-Baustein 16 zugewandten Enden jeweils mit einem ersten Bondpad 24a versehen. Zum Anschluss der Bonddrähte an diese ersten Bondpads 24a wird vom IC-Baustein 16 her gesehen hinter diesen Bondpads zur Herstellung der Bondverbindungen ein in Figur 2 gestrichelt dargestellter, begrenzter Freiraum 29 für das Zuführen und Abführen eines Bondwerkzeuges benötigt. Aus Figur 2 ist erkennbar, dass die Stromschienen 24 als Einlegeteile weitgehend in Isolierstoff einer Grundplatte 30 eingebettet sind, die ein Fenster 31 für die Anordnung des Metallblocks 17 mit dem IC-Baustein 16 aufweist. Der IC-Baustein 16 mit dem Metallblock 17 sowie die Grundplatte 30 mit den Stromschienen 24 sind mitsamt dem Kühlkörper 19 von einem Rahmen 32 eingefasst, um den Raum innerhalb dieses Rahmens 32 mit den darin angeordneten Bauelementen von einer nicht dargestellten Vergussmasse als Korrosionsschutz abzudecken.

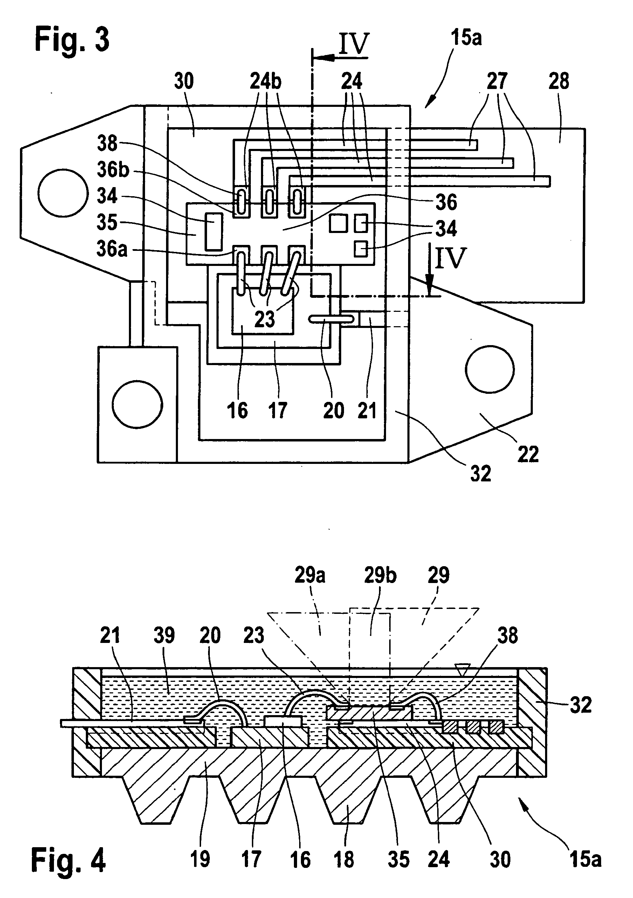

Für die wahlweise Aufrüstung des Reglers 15 mit zusätzlichen Komponenten sind die Stromschienen 24 jeweils hinter dem begrenzten Freiraum 29 mit dem Abstand a zu ihrem ersten Bondpad 24a mit einem weiteren Bondpad 24b versehen, um dort wahlweise zusätzliche elektronische Bauteile anschließen zu können. Dabei ist der Abstand a zwischen dem ersten und dem zweiten Bondpad 24a und 24b der Stromschienen 24 so groß gewählt, dass er einen mehrfach nutzbaren begrenzten Freiraum für das Zuführen und Abführen des Bondwerkzeuges zu den beiden Bondpads einer jeden Stromschiene 24 bildet, wie dies zu Figur 4 näher erläutert wird.

In dem Ausführungsbeispiel nach Figur 1 und 2 ist der Regler 15 in Einfachausführung nur mit dem IC-Baustein 16 ausgestattet, dessen Bonddraht-Anschlüsse 23 direkt über die ersten Bondpads 24a mit den Stromschienen 24 der Steckanschlüsse 27 am Steckerteil 28 verbunden sind. Dieser Regler 15 lässt sich aber auch wahlweise durch zusätzliche Komponenten für Zusatzfunktion und höhere Sicherheitsstandards aufrüsten, wobei dann die zweiten Bondpads 24b verwendet werden können.

Figur 3 und 4 zeigen ein solches Ausführungsbeispiel des Reglers 15a. Dort sind neben dem IC-Baustein 16 zusätzliche elektronische Bauteile 34 für eine höhere Betriebssicherheit des Reglers 15a auf einer Substratplatte 35 in bekannter SMD-Technik aufgebracht und in einem Anschlussbereich 36 verschaltet. Die Substratplatte 35 ist zwischen dem IC-Baustein 16 und den zweiten Bondpads 24b der Stromschienen 24 angeordnet und liegt auf den Enden der Stromschienen 24 mit den ersten Bondpads 24a auf. Sie ist auf der Grundplatte 30 fixiert. Die Bonddraht-Anschlüsse 23 des IC-Bausteins 16 werden hier zunächst mit weiteren Bondpads 36a im Anschlussbereich 36 der Substratplatte 35 kontaktiert und von dort über weitere Bonddraht-Anschlüsse 38 an die zweiten Bondpads 24b der Stromschienen 24 angeschlossen. Der IC-Baustein 16 ist somit bei dieser Ausführung indirekt über die Substratplatte 35 mit den zusätzlichen elektronischen Bauteilen 34 an den Steckanschlüssen 27 des Steckerteils 28 angeschlossen. In Figur 4 ist dargestellt, wie in diesem Fall der Freiraum 29 zwischen den ersten und zweiten Bondpads für das Zuführen und Abführen des Bondwerkzeuges zur Herstellung der Bonddraht-Anschlüsse 23 und 38 im Anschlussbereich 36 der Substratplatte 35 mehrfach genutzt werden kann. Dort werden zunächst die Bonddraht-Anschlüsse 23 vom IC-Baustein 16 mit einem nicht dargestellten Bondwerkzeug auf den Anschlussbereich 36 der Substratplatte 35 geführt und dort an den weiteren Bondpads 36a angeschlossen. Der dabei benötigte Freiraum 29 für das Bondwerkzeug ist in Figur 4 gestrichelt dargestellt. Anschließend werden Bondwerkzeug und Regler 15a um 180° relativ zueinander gedreht. Nunmehr werden die Bonddraht-Anschlüsse 38 mittels des Bondwerkzeuges jeweils von dem zweiten Bondpad 24b der Stromschienen 24 auf dem Anschlussbereich 36 der Substratplatte 35 geführt und dort an den Bondpads 36b kontaktiert. Dabei wird das Bondwerkzeug über einen strichpunktiert dargestellten Freiraum 29a im Anschlussbereich 36 zu- und abgeführt. Im Anschlussbereich 36 der Substratplatte 35 überschneiden sich dabei die vom Bondwerkzeug benötigten Freiräume 29, 29a. Dieser Überschneidungsbereich 29b entspricht in etwa dem Abstand a zwischen dem ersten und zweiten Bondpad 24a und 24b gemäß Figur 1. Der Bonddrahtanschluss 20 zwischen Metallblock 17 und Anschlussplatte 22 bleibt dabei unverändert.

Der Freiraum 29, der nach dem ersten Ausführungsbeispiel gemäß Figur 2 für das Verfahren des Bondwerkzeuges zum Anschluss der Bonddrähte 23 an die ersten Bondpads 24a benötigt wird, ist erfindungsgemäß derart angeordnet, dass er im Falle einer Aufrüstung des Reglers 15 mit Zusatzkomponenten nach dem zweiten Ausführungsbeispiel gemäß Figur 4 sowohl zur Anbringung der Substratplatte 35 mit den zusätzlichen elektronischen Bauteilen 34 als auch zum Anschluss dieser Zusatzkomponenten an den IC-Baustein 16 einerseits und an die Stromschienen 24 andererseits mehrfach genutzt wird. Für beide Ausführungsformen des Reglers 15 werden die gleichen Steckerteile 28 mit den Stromschienen 24 verwendet. Nach Herstellung der Bondverbindungen wird der Innenraum des Rahmens 32 oberhalb der Grundplatte 30 gemäß Figur 4 mit einem Silikongel 39 gefüllt.

## Patentansprüche

1. Elektronische Baueinheit, insbesondere Regler (15) für Generatoren in Kraftfahrzeugen, mit einem IC-Baustein (16) auf einem Kühlkörper (19) und mit Bonddraht-Anschlüssen (23) des IC-Bausteins an mehrere Leiter (24), wobei die Leiter (24) an ihrem dem IC-Baustein zugewandten Ende jeweils mit einem ersten Bondpad (24a) versehen sind, hinter dem vom IC-Baustein her gesehen ein begrenzter Freiraum (29) für das Zu- und Abführen eines Bohdwerkzeuges vorgesehen ist, **dadurch gekennzeichnet, dass** die leiter die Form von Stromschienen aufweisen, die zu Steckanschlüssen (27) eines Steckerteils (28) führen, und dass die zu den Steckauschlüssen (27) führenden Leiter (24) dass die Leiter die Form von Stromschienen aufweisen, die zu Steckanschlüssen (27) eines Steckerteils (28) führen, und jeweils hinter dem begrenzten Freiraum (29) mit Abstand (a) zu ihrem ersten Bondpad (24a) mit einem weiteren Bondpad (24b) für weitere Bonddraht-Anschlüsse (38) mindestens eines wahlweise zusätzlich einzusetzenden elektronischen Bauteiles (34) versehen sind.

2. Elektronische Baueinheit nach Anspruch 1, **dadurch gekennzeichnet, dass** der Abstand (a) zwischen dem ersten und dem zweiten Bondpad (24a, 24b) der Leiter (24) einen mehrfach nutzbaren begrenzten Freiraum (29) für das Zu - und Abführen des Bondwerkzeuges zu den beiden Bondpads (24a, 24b) bildet.

3. Elektronische Baueinheit nach Anspruch 2, **dadurch gekennzeichnet, dass** die Bonddraht-Anschlüsse (23) des IC-Bausteins (16) wahlweise direkt an den ersten Bondpads (24a) oder indirekt über das mindestens eine zusätzliche elektronische Bauteil (34) an den zweiten Bondpads (24b) mit den Leitern (24) verbunden sind.

4. Elektronische Baueinheit nach Anspruch 3, **dadurch gekennzeichnet, dass** die Leiter (24) als Stromschienen weitgehend in Isolierstoff (30), vorzugsweise als Einlegeteile, eingebettet sind.

5. Elektronische Baueinheit nach Anspruch 3, **dadurch gekennzeichnet, dass** mehrere zusätzliche elektronische Bauteile (34) auf einer Substratplatte (35) verschaltet sind, die vorzugsweise zwischen dem IC-Baustein (16) und den zweiten Bondpads (24b) der Leiter (24) angeordnet ist.

6. Elektronische Baueinheit nach Anspruch 5, **dadurch gekennzeichnet, dass** die Substratplatte (35) auf den dem IC-Baustein (16) zugewandten Enden der Leiter (24) mit den ersten Bondpads (24a) angeordnet ist.

7. Elektronische Baueinheit nach Anspruch 6, **dadurch gekennzeichnet, dass** die Substratplatte (35) im Bereich des Freiraumes (29) einen Anschlussbereich (36) aufweist, in dem die Bonddraht-Anschlüsse (23) vom IC-Baustein sowie weitere Bonddraht-Anschlüsse (38) von den zweiten Bondpads (24b) der Leiter (24) unter Mehrfachnutzung des Freiraumes (29b) zum Zu- und Abführen des Bondwerkzeuges kontaktiert sind.

8. Elektronische Baueinheit nach einem der vorherigen Ansprüche, **dadurch gekennzeichnet, dass** der IC-Baustein (16), das wahlweise mindestens eine zusätzliche elektronische Bauteil (34) und die Bondpads (24a, 24b) der Leiter (24) von einem Rahmen (32) eingefasst und innerhalb des Rahmens (32) von einer Vergussmasse (39) als Korrosionsschutz abgedeckt sind.

## Claims

1. Electronic device, in particular controller (15) for generators in motor vehicles, comprising an IC component (16) on a heat sink (19) and comprising bonding wire connections (23) of the IC component to a plurality of conductors (24), wherein the conductors (24) are in each case provided with a first bonding pad (24a) at their end facing the IC component, behind which bonding pad, as seen from the IC component, a delimited free space (29) for leading in and leading away a bonding tool is provided, **characterized in that** the conductors have the form of busbars which lead to plug connections (27) of a plug part (28), and **in that** the conductors (24) leading to the plug connections (27) are in each case provided, behind the delimited free space (29) at a distance (a) from their first bonding pad (24a), with a further bonding pad (24b) for further bonding wire connections (38) of at least one electronic component (34) which is optionally additionally to be used.

2. Electronic device according to Claim 1, **characterized in that** the distance (a) between the first and second bonding pads (24a, 24b) of the conductors (24) forms a multiply usable delimited free space (29) for leading in and leading away the bonding tool with respect to the two bonding pads (24a, 24b).

3. Electronic device according to Claim 2, **characterized in that** the bonding wire connections (23) of the IC component (16) are optionally connected to the conductors (24) directly at the first bonding pads (24a) or indirectly via the at least one additional electronic component (34) at the second bonding pads (24b).

4. Electronic device according to Claim 3, **characterized in that** the conductors (24) as busbars are largely embedded in insulating material (30), preferably as insert parts.

5. Electronic device according to Claim 3, **characterized in that** a plurality of additional electronic components (34) are interconnected on a substrate board (35), which is preferably arranged between the IC component (16) and the second bonding pads (24b) of the conductors (24).

6. Electronic device according to Claim 5, **characterized in that** the substrate board (35) is arranged on the ends - facing the IC component (16) - of the conductors (24) with the first bonding pads (24a).

7. Electronic device according to Claim 6, **characterized in that** the substrate board (35) has in the region of the free space (29) a connection region (36), in which the bonding wire connections (23) from the IC component and further bonding wire connections (38) from the second bonding pads (24b) of the conductors (24) are contact-connected with multiple use of the free space (29b) for leading in and leading away the bonding tool.

8. Electronic device according to any of the preceding claims, **characterized in that** the IC component (16), the optional at least one additional electronic component (34) and the bonding pads (24a, 24b) of the conductors (24) are enclosed by a frame (32) and are covered by a potting compound (39) as protection against corrosion within the frame (32).

## Revendications

1. Module électronique, en particulier régulateur (15) pour générateur de véhicule automobile,
le module présentant un composant IC (16) placé sur un corps de refroidissement (19),
des bornes (23) pour fils de raccordement du composant IC étant raccordées à plusieurs conducteurs (24),
les conducteurs (24) étant dotés à leur extrémité tournée vers le composant IC d'un premier tampon de raccordement (24a) en arrière duquel, vu du composant IC, un espace libre limité (29) est prévu pour l'amenée et l'enlèvement d'un outil de raccordement,
**caractérisé en ce que**
les conducteurs présentent la forme de rails de courant qui conduisent aux bornes de fiche (27) d'une partie d'enfichage (28) et
**en ce que** les conducteurs (24) conduisant aux bornes de fiches (27) sont dotés derrière l'espace libre limité (29), à distance (a) de leur premier tampon de raccordement (24a), d'un autre tampon de raccordement (24b) pour d'autres bornes (38) pour fils de raccordement d'au moins un composant électronique (34) qui peut être utilisé sélectivement en supplément.

2. Module électronique selon la revendication 1, **caractérisé en ce que** la distance (a) entre le premier et le deuxième tampon de raccordement (24a, 24b) des conducteurs (24) forme un espace libre limité (29) utilisable plusieurs fois pour l'amenée et l'enlèvement de l'outil de raccordement vers les deux tampons de raccordement (24a, 24b).

3. Module électronique selon la revendication 2, **caractérisé en ce que** les bornes (23) pour fils de raccordement du composant IC (16) sont reliées directement aux conducteurs (24), sélectivement directement sur le premier tampon de raccordement (24a) ou indirectement sur le deuxième tampon de raccordement (24b) par l'intermédiaire d'au moins un composant électronique supplémentaire (34).

4. Module électronique selon la revendication 3, **caractérisé en ce que** les conducteurs (24) configurés comme rails de courant sont largement incorporés dans une substance isolante (30), de préférence sous la forme de pièces encastrées.

5. Module électronique selon la revendication 3, **caractérisé en ce que** plusieurs composants électroniques supplémentaires (34) sont raccordés sur une plaque de support (35) disposée de préférence entre le composant IC (16) et les deuxièmes tampons de raccordement (24b) des conducteurs (24).

6. Module électronique selon la revendication 5, **caractérisé en ce que** la plaque de support (35) est disposée avec les premiers tampons de raccordement (24a) sur les extrémités des conducteurs (24) tournées vers le composant IC (16).

7. Module électronique selon la revendication 6, **caractérisé en ce que** la plaque de support (35) présente au niveau de l'espace libre (29) une partie de borne (36) dans laquelle les bornes (23) pour fils de raccordement du composant IC ainsi que d'autres bornes (38) pour fils de raccordement des deuxièmes tampons de raccordement (24b) des conducteurs (24) sont mises en contact en utilisant plusieurs fois l'espace libre (29b) pour amener et retirer l'outil de raccordement.

8. Module électronique selon l'une des revendications précédentes, **caractérisé en ce que** le composant IC (16), le ou les premiers composants électroniques supplémentaires (34) et les tampons de raccordement (24a, 24b) des conducteurs (24) sont entourés par un cadre (32) et sont recouverts à l'intérieur du cadre (32) par une pâte de scellement (39) qui sert de protection contre la corrosion.
